# EUROPÄISCHE PATENTSCHRIFT

(11) **EP 2 201 619 B1**
(45) Veröffentlichungstag und Bekanntmachung des Hinweises auf die Patenterteilung: **10.07.2013**
(21) Anmeldenummer: 08835093.9
(22) Anmeldetag: 25.09.2008
(51) Int. Cl.: H01L 41/083, H01L 41/273

(54) **PIEZOELEKTRISCHES VIELSCHICHTBAUELEMENT**
MULTI-LAYER PIEZOELECTRIC COMPONENT
COMPOSANT PIÉZO-ÉLECTRIQUE MULTICOUCHE

(30) Priorität: 26.09.2007 DE 102007046077
(43) Veröffentlichungstag der Anmeldung: 30.06.2010
(73) Patentinhaber: Epcos AG, 81669 München (DE)
(72) Erfinder: GLAZUNOV, Alexander, A-8530 Deutschlandsberg (AT)
(74) Vertreter: Epping - Hermann - Fischer
(86) Internationale Anmeldenummer: PCT/EP2008/062858
(87) Internationale Veröffentlichungsnummer: WO 2009/043802

(56) Entgegenhaltungen:
- DE-A1-102006 035 470
- US-B1- 6 285 116

## Beschreibung

Es wird ein piezoelektrisches Vielschichtbauelement, insbesondere ein piezoelektrisches Vielschichtbauelement mit absichtlich teilweise delaminierbaren piezokeramischen Schichten, beschrieben.

In vielen Designs von piezoelektrischen Vielschichtbauelementen sind Elektrodenschichten nur auf einem Teil einer piezokeramischen Schicht aufgebracht. Der übrige Bereich auf der piezokeramischen Schicht ist somit elektrisch isolierend um Kurzschlüsse zwischen einem Außenkontakt und einer gegenpoligen Elektrodenschicht zu vermeiden. Dieser Bereich frei von einer Elektrodenschicht kann als inaktive Zone bezeichnet werden.

Da die elektrische Betriebsspannung zwischen gegenpoligen Elektrodenschichten nur im mittleren Bereich, d.h., in der aktiven Zone des Vielschichtbauelements angelegt ist, kann nur dieser mittlere Bereich aufgrund des inversen piezoelektrischen Effekts sich ausdehnen. Die zwischen gleich gepolten Elektrodenschichten angeordneten piezokeramischen Schichten expandieren dabei weniger, sodass es zu einer mechanischen Klemmung zwischen der inaktiven Zone und der aktiven Zone des Vielschichtbauelements kommen kann. Dieser Klemmeffekt reduziert die gesamte Ausdehnung des Vielschichtbauelements, welches ein Nachteil für dessen Anwendung darstellt.

Aus WO 2006/087871-A1 ist ein piezoelektrisches Vielschichtbauelement mit seitlich angebrachten, rissinduzierenden, elektrisch leitfähigen Schichten bekannt.

Weitere Beispiele finden sich in US 6285116 und DE 102006035470.

Eine zu lösende Aufgabe besteht darin, ein piezoelektrisches Vielschichtbauelement anzugeben, welches einen verbesserten Auslenkungsweg aufweist. Eine weitere zu lösende Aufgabe besteht darin, ein piezoelektrisches Vielschichtbauelement anzugeben, welches einen verbesserten Auslenkungsweg aufweist und über einen längeren Zeitraum funktionstüchtig bleibt.

Es wird ein piezoelektrisches Vielschichtbauelement mit einem Stapel von übereinander angeordneten piezokeramischen Schichten und Elektrodenschichten angegeben, wobei zumindest eine piezokeramische Schicht mit einer nach einem vorgegebenen Muster strukturierten Schicht in einer piezoelektrisch inaktiven Zone bedruckt ist.

Die strukturierte Schicht weist zumindest ein Verbindungselement auf, durch das in Stapelrichtung benachbarte piezokeramischen Schichten mit einer ersten Festigkeit mechanisch miteinander verbunden sind.

Die strukturierte Schicht weist neben den Verbindungselementen Zwischenräume auf, die mit piezokeramischem Material der benachbarten piezokeramischen Schichten gefüllt sind. Der Zwischenraum kann vollständig oder nur teilweise, d.h. mit übrig bleibenden Lücken, mit dem piezokeramischen Material gefüllt sein. Dabei weist die mechanische Verbindung zwischen den benachbarten piezokeramischen Schichten in dem Zwischenraum bzw. in dem Bereich des Zwischenraumes neben den Verbindungselementen eine zweite Festigkeit auf, welche geringer ist, als die oben genannte erste Festigkeit. Insbesondere ist die zweite Festigkeit der mechanischen Verbindung zwischen den benachbarten piezokeramischen Schichten geringer, als die Festigkeit der mechanischen Verbindung zwischen den benachbarten piezokeramischen Schichten in der aktiven Zone des Vielschichtbauelements.

Da der Zwischenraum neben den Verbindungselementen der strukturierten Schicht mit einem piezokeramischen Material gefüllt ist, sodass die benachbarten piezokeramischen Schichten dadurch mechanisch miteinander verbunden sind, kann die strukturierte Schicht auch als durchgehende, d.h. lückenlose oder zumindest nahezu lückenlose Schicht betrachtet werden. Dabei weist die strukturierte Schicht Bereiche auf, welche mechanisch fester mit den benachbarten piezokeramischen Schicht verbunden sind, als andere Bereiche der strukturierten Schicht.

Die Verbindungselemente der strukturierten Schichten sorgen des Weiteren dafür, dass zwei in Stapelrichtung benachbarte piezokeramische Schichten an ihren jeweiligen Randbereichen einen mechanischen Kontakt miteinander bilden, insbesondere damit das Vielschichtbauelement während seiner Herstellung, vor dem Verpressen des Stapels, nicht gebrochen oder zerstört wird.

Die strukturierte Schicht befindet sich zumindest in der inaktiven Zone des Vielschichtbauelements, die dem beschriebenen Klemmeffekt ausgesetzt ist. Sie kann jedoch bis in die aktive Zone weiter im Innern des Vielschichtbauelements reichen. Verbindungselemente sowie die Räume neben ihnen können also bis in die aktive Zone des Vielschichtbauelements reichen.

Aufgrund der Bereiche, in denen die benachbarten piezokeramischen Schichten in der inaktiven Zone mit reduzierter Festigkeit miteinander verbunden sind, können sich die piezokeramischen Schichten beim Anlegen einer Betriebsspannung auf das Vielschichtbauelement teilweise delaminieren. Sie werden von der Ausdehnung des Vielschichtbauelements im mittleren Bereich bzw. in seiner aktiven Zone mit reduziertem Widerstand mitgezogen. Dadurch kann ein Klemmeffekt zwischen der aktiven und der inaktiven Zone des Vielschichtbauelements vermieden oder zumindest reduziert werden. Damit kann der gesamte Auslenkungsweg des piezoelektrischen Vielschichtbauelements, insbesondere im axial zentralen Bereich des Stapels, erhöht werden. Darüber hinaus ergibt die teilweise Delaminierbarkeit der piezokeramischen Schichten in der inaktiven Zone aufgrund der dort geringeren mechanischen Verbindung den vorteilhaften Effekt, dass das Vielschichtbauelement dort gegenüber Zug- bzw. Klemmspannungen mechanisch entlastet wird, sodass es zu keiner unkontrollierten Rissbildung innerhalb des Stapels, insbesondere zwischen zwei gegenpoligen Elektrodenschichten, kommen kann. Somit kann auch die Dauer der Funktionstüchtigkeit des piezoelektrischen Vielschichtbauelements verlängert werden.

Gemäß einer Ausführungsform umfasst die strukturierte Schicht zylinderförmige Verbindungselemente, die einen kreisförmigen oder einen vieleckförmigen Umriss aufweisen könnten. Alternativ ist das zumindest eine Verbindungselement gitterförmig, wobei sich mehrere Linien aus auf der piezokeramischen Schicht aufgedrucktem Material kreuzen und dabei Zwischenräume einschließen, die mit Material benachbarter piezokeramischer Schichten gefüllt sind. Zusätzlich oder alternativ kann ein Verbindungselement einer strukturierten Schicht ringförmig sein.

Gemäß einer Ausführungsform des Vielschichtbauelements sind mehrere ringförmige Verbindungselemente einer strukturierten Schicht konzentrisch auf einer piezokeramischen Schicht nebeneinander angeordnet und verbinden benachbarte piezokeramische Schichten im Stapel miteinander. Neben bzw. zwischen den ringförmigen Verbindungselementen sind mit dem Material von benachbarten piezokeramischen Schichten gefüllte Zwischenräume vorhanden.

Ungeachtet der beschriebenen Ausführungsformen können die Verbindungselemente bzw. der neben ihnen mit piezokeramischem Material gefüllten Bereiche beliebig geformt sein. Vorzugsweise weist die strukturierte Schicht mehrere gleichmäßig auf der piezokeramischen Schicht verteilte Verbindungselemente auf. Dabei können diese im Wesentlichen homogen bzw. äquidistant zueinander angeordnet sein.

Die Elektrodenschichten des Stapels enthalten vorzugsweise eine der folgenden Materialien bzw. Legierungen: Silber, Palladium, Nickel, Kupfer.

Die piezokeramischen Schichten enthalten vorzugsweise eine Keramik auf der Basis von Blei-Zirkonat-Titanat (PZT).

Es wird bevorzugt, dass die strukturierte Schicht bzw. ein Verbindungselement der Schicht ein Material enthält, welches in einer mit ihr verbundenen piezokeramischen Schicht enthalten ist. Dabei werden vorteilhafterweise unerwünschte chemische Reaktionen, insbesondere während der Herstellung des Vielschichtbauelements, zwischen der strukturierten Schicht und einer mit ihr verbundenen piezokeramischen Schicht vermieden. Zusätzlich oder alternativ kann die strukturierte Schicht bzw. ein von ihr umfasstes zumindest ein Verbindungselement ein Metall enthalten, welches auch in einer Elektrodenschicht enthalten ist.

Gemäß einer Ausführungsform des Vielschichtbauelements ist die strukturierte Schicht auf derselben piezokeramischen Schicht angeordnet, wie eine Elektrodenschicht. Sie kann jedoch auch auf einer anderen piezokeramischen Schicht angeordnet sein, als auf einer, auf der eine Elektrodenschicht angeordnet ist. Das ergibt den Vorteil, dass mit einer geeigneten, unterschiedliche Muster umfassenden Maske, jeweils für eine Elektrodenschicht und für eine strukturierte Schicht, gleichzeitig eine Elektrodenschicht und eine strukturierte Schicht der beschriebenen Art auf eine piezokeramischen Schicht aufgebracht werden können.

Vorzugsweise sind mehrere strukturierte Schichten auf mehreren piezokeramischen Schichten über die Höhe des Stapels des Vielschichtbauelements verteilt. Ein dadurch kumulativ reduzierter Klemmeffekt erhöht den erreichbaren Auslenkungsweg des piezoelektrischen Vielschichtbauelements vorteilhafterweise noch weiter.

Die Elektrodenschichten des Vielschichtbauelements sind vorzugsweise mit einem als Schicht ausgeführten Außenkontakt kontaktiert, der auf einer parallel zur Stapelrichtung verlaufenden Außenfläche des Stapels angeordnet ist. Andere Formen eines Außenkontaktes sind jedoch möglich, wie beispielsweise kabel- bzw. stabförmig.

Die mit einer strukturierten Schicht bedruckte piezokeramische Schicht kann eine bereits mit einer Elektrodenschicht bedruckte piezokeramische Schicht sein. Dabei wird die strukturierte Schicht, vorzugsweise mit einem Abstand zur Elektrodenschicht, neben diese auf die piezokeramische Schicht aufgebracht.

Zwischen mit Elektrodenschichten bedruckten piezokeramischen Schichten können gemäß einer Ausführungsform mehrere unbedruckte piezokeramische Schichten übereinander gestapelt sein. Diese können jeweils mit strukturierten Schichten der beschriebenen Art bedruckt sein.

Es wird ein Verfahren zur Herstellung eines piezoelektrischen Vielschichtbauelements angegeben, bei dem ein Stapel von Elektrodenschichten und bedruckten piezokeramischen Schichten gebildet wird. Es handelt dabei um piezokeramische Grünfolien und jeweils auf solche als Schicht aufgedrucktes Elektrodenmaterial. Die piezokeramischen Folien können beim Verstapeln bereits temperaturvorbehandelt sein und / oder bereits Zusätze enthalten, welche deren Handhabbarkeit während der Herstellung bzw. des Transports begünstigen. Dabei kann es sich um organische Binder handeln.

Zumindest eine piezokeramische Schicht wird vor dem Verstapeln zumindest in einer piezoelektrisch inaktiven Zone im jeweiligen Randbereich der piezokeramischen Schicht mit einer mit einem vorgegebenen Muster strukturierten Schicht bedruckt.

Das vorgegebene Muster der auf die zumindest eine piezokeramische Schicht aufgedruckten strukturierten Schicht ergibt Verbindungselemente und zwischen ihnen vorhandene Zwischenräume, welche zunächst Hohlräume oder Lücken sind. Die Verbindungselemente verbinden bei und nach dem Verstapeln benachbarte piezokeramische Schichten miteinander.

Das Bedrucken der zumindest einen piezokeramischen Schicht erfolgt vorzugsweise anhand eines Siebdruckverfahrens. Das Verpressen eines Materials durch die Löcher bzw. Aussparungen des Siebs ergibt das Muster, insbesondere die Verbindungselemente des Musters. Bei dem Material kann es sich um ein piezokeramisches Material oder um ein elektrisch leitendes Material, insbesondere auch ein Material, welches für die Elektrodenschichten verwendet wird, handeln.

Der Stapel kann anschließend verpresst werden, so dass piezokeramische Schichten geringfügig erweichen und ihr jeweiliges Material in die Lücken bzw. Zwischenräume einer zwischen ihnen angeordneten strukturierten Schicht fließt. Beim Verpressen wurde nämlich beobachtet, dass sich die piezokeramischen Schichten unter Druck und erhöhter Temperatur ausreichend verflüssigen, um die Lücken der strukturierten Schicht zumindest so ausreichend zu füllen, dass sie sich im Zwischenraum neben den Verbindungselementen mechanisch verbinden. Dabei entsteht jedoch eine mechanische Verbindung zwischen den benachbarten piezokeramischen Schicht in den genannten Zwischenräumen, die weniger fest ist, als die durch die Verbindungselemente beim Verpressen ergebende mechanische Verbindung zwischen den piezoelektrischen Schichten.

Der Grund für die geringere zweite Festigkeit der mechanischen Verbindung zwischen den benachbarten piezoelektrischen Schichten in der Zwischenräumen liegt darin, dass dort die Verbindung nicht an erster Stelle über eine Presskraft erreicht wird, sondern lediglich über das in den zu diesem Zweck zur Verfügung stehenden Zwischenräumen stattfindende Vermischen und Binden der Materialien der piezokeramischen Schichten.

Die beschriebenen Gegenstände werden anhand der folgenden
Figuren und Ausführungsbeispiele näher erläutert. Dabei zeigt:
   - Figur 1A: ein piezoelektrisches Vielschichtbauelement in einem Längsschnitt,
   - Figur 1B: ein piezoelektrisches Vielschichtbauelement in einer seitlichen Querschnittsansicht,
   - Figur 2A: eine seitliche Querschnittsansicht eines Bereichs eines Vielschichtstapels mit strukturierten Schichten, welche auf beiden Randbereichen einer einzigen piezokeramischen Schicht aufgebracht sind,
   - Figur 2B: eine seitliche Querschnittsansicht eines Teils eines Vielschichtstapels mit strukturierten Schichten, welche einzeln auf unterschiedlichen piezokeramischen Schichten aufgebracht sind,
   - Figur 2C: eine seitliche Querschnittsansicht eines Teils eines Vielschichtstapels mit mehreren auf einer gemeinsamen piezokeramischen Schicht aufgebrachten strukturierten Schichten, welche sich ausschließlich in einer inaktiven Zonen befinden,
   - Figur 2D: eine seitliche Querschnittsansicht eines Teils eines Vielschichtstapels mit mehreren, auf gemeinsamen piezokeramischen Schichten aufgebrachten strukturierten Schichten, welche sich sowohl in einer inaktiven als auch in einer aktiven Zone befinden,
   - Figur 2E: eine seitliche Querschnittsansicht eines Teils eines Vielschichtstapels mit einzelnen, auf unterschiedlichen piezokeramischen Schichten aufgebrachten und neben Elektrodenschichten angeordneten strukturierten Schichten,
   - Figur 3A: eine Draufsicht auf eine strukturierte Schicht mit zylinderförmigen Verbindungselementen,
   - Figur 3B: eine Draufsicht auf eine auf einer piezokeramischen Schicht angeordneten, gitterförmigen Struktur einer Schicht,
   - Figur 3C: eine Draufsicht auf eine strukturierte Schicht mit konzentrischen Strukturen,
   - Figur 4A: eine seitliche Querschnittsansicht eines Teils eines Vielschichtstapels mit einer strukturierten Schicht vor dem Verpressen des Stapels,
   - Figur4B: eine seitliche Querschnittsansicht eines Teils eines Vielschichtstapels mit einer strukturierten Schichten bei bzw. nach dem Verpressen des Stapels.

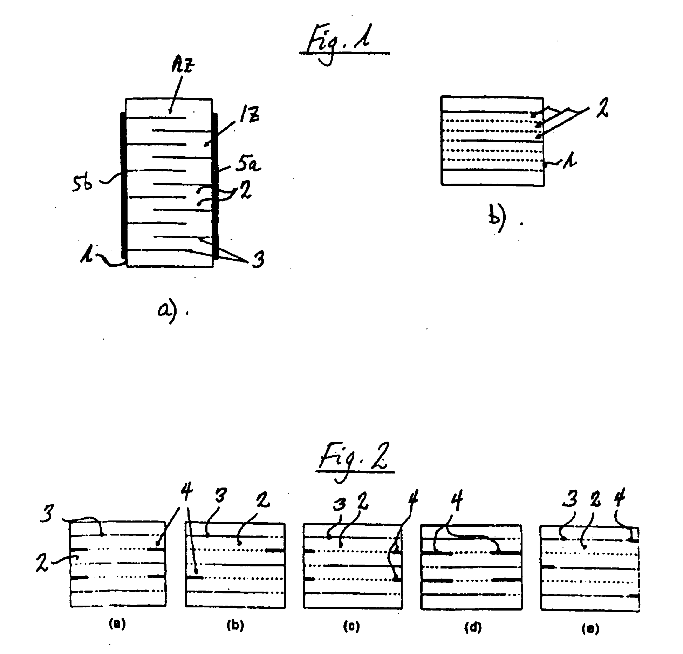

Figur 1A zeigt einen Längsschnitt eines piezoelektrischen Vielschichtbauelements mit einem Stapel 1 von übereinander angeordneten piezokeramischen Schichten 2 und Elektrodenschichten 3, wobei der ausschließlich mit einem Dielektrikum gefüllte Raum zwischen zwei gleich gepolten Elektrodenschichten eine inaktive Zone IZ bildet und der in orthogonaler Projektion überlappende Bereich zwischen gegenpoligen Elektrodenschichten eine aktive Zone AZ des Vielschichtbauelements ist, welche bei angelegter Betriebsspannung in Längsrichtung expandiert. Auch werden als Schichten ausgeführte Außenkontakte 5a und 5b gezeigt, welche an den senkrecht zu den piezokeramischen Schichten 2 verlaufenden Seitenflächen des Vielschichtbauelements angeordnet sind. Zwischen zwei benachbarten Elektrodenschichten 3 können mehrere piezokeramische Schichten 2 vorhanden sein. Die Außenkontakte 5a, 5b können mittels einer Metallpaste eingebrannt oder galvanisch auf die Seitenfläche(n) des Stapels aufgetragen sein.

Figur 1B ist eine seitliche Querschnittsansicht eines Teils eines Stapels 1, wobei zwischen zwei in Stapelrichtung benachbarten Elektrodenschichten 3 mehrere piezokeramische Schichten 2 angeordnet bzw. übereinander gestapelt sind. Die unterbrochenen Linien der Figur zeigen die Grenzen zwischen zwei benachbarten piezokeramischen Schichten.

Figuren 2A bis 2E zeigen jeweils Bereiche eines Vielschichtbauelements mit einem Aufbau gemäß Figur 1A bzw. Figur 1B.

Figur 2A zeigt anhand fett gezeichneter horizontaler Linien die Positionen von strukturierten Schichten 4, mit denen in Stapelrichtung benachbarte piezokeramische Schichten 2 mechanisch weniger fest miteinander verbunden werden, als sie weiter im Innern des Stapels miteinander verbunden sind. Auf jeder piezokeramischen Schicht 2 sind mehrere sich im Randbereich der piezokeramischen Schicht 2 befindliche strukturierte Schichten 4 aufgebracht. Vorzugsweise liegen sich diese auf einer gemeinsamen piezokeramischen Schicht 2 gegenüber.

Figur 2B zeigt eine Schnittansicht des piezoelektrischen Vielschichtbauelements gemäß Figur 2A, wobei eine einzige strukturierte Schicht 4 auf jeweils einer piezokeramischen Schicht 2 zwischen zwei in Stapelrichtung benachbarten Elektrodenschichten 3 vorhanden ist.

Der mit der Figur 2C abgebildete Teil des Stapels eines Vielschichtbauelements entspricht demjenigen der Figur 2A, jedoch mit dem Unterschied, dass die flächigen Ausdehnungen der strukturierten Schichten 4 parallel zur piezokeramischen Schicht kleiner sind, als diejenigen gemäß Figur 2A. Insbesondere sind die strukturierten Schichten 4 lediglich in inaktiven Zonen IZ (siehe Figur 1A) des Stapels 1 angeordnet, in der nominell keine oder lediglich eine minimale durch einen piezoelektrischen Effekt hervorgerufene Ausdehnung des Stapels in Längsrichtung zustande kommt.

Figur 2D ist eine Schnittansicht des piezoelektrischen Vielschichtbauelements gemäß Figur 2A bzw. Figur 2C, wobei jeweils auf einer piezokeramischen Schicht 2, welche zwischen zwei in Stapelrichtung benachbarten Elektrodenschichten 3 angeordnet ist, zwei strukturierte Schichten 4 angeordnet sind. Die Flächenausdehnungen parallel zur piezokeramischen Schicht der strukturierten Schichten 4 sind größer, als gemäß den Abbildungen der Figuren 2A und 2C gezeigt, wobei die strukturierten Schichten von aktiven Zonen AZ zwischen benachbarten, gegenpoligen Elektrodenschichten 3 bis hin zu einer Seitenfläche, auf der ein Außenkontakt 5a bzw. 5b gemäß Figur 1A angeordnet sein kann, reichen.

Zurückblickend auf die Figur 2B können die Flächenausdehnungen der dort gezeigten strukturierten Schichten genauso groß sein wie mit den Figuren 2C und 2D dargestellt bzw. beschrieben.

Figur 2E zeigt eine Schnittansicht eines piezoelektrischen Vielschichtbauelements, wobei jeweils eine strukturierte Schicht 4 auf derselben piezokeramischen Schicht 2 angeordnet ist, wie eine Elektrodenschicht 3. Dabei sind die jeweiligen strukturierten Schichten 4 lediglich in inaktiven Zonen IZ des Stapels 1 des Vielschichtbauelements angeordnet.

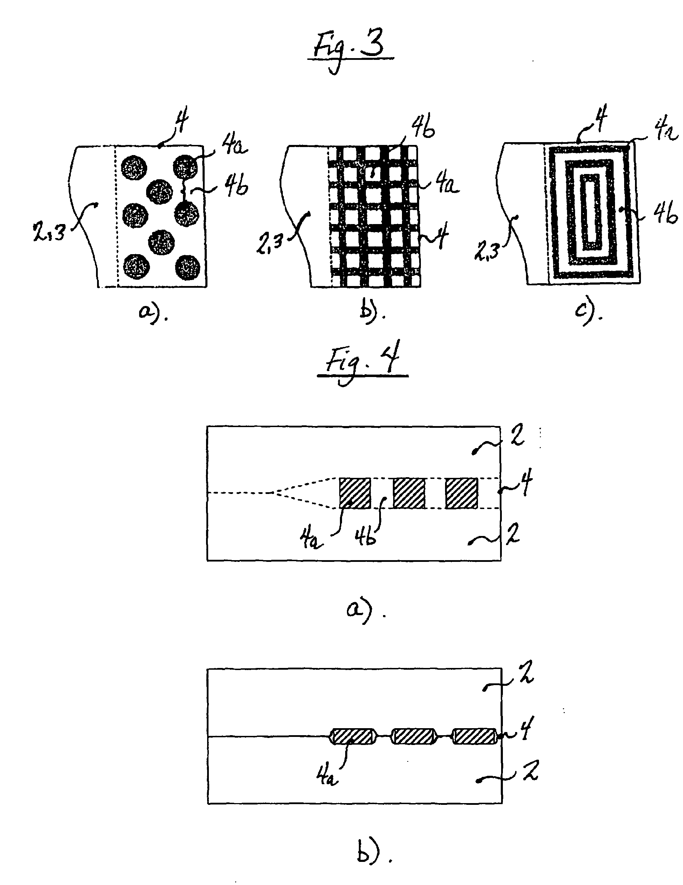

Die strukturierten Schichten 4 selbst werden mit den folgenden Figuren 3 und 4 näher erläutert.

Figur 3A ist eine Draufsicht auf eine strukturierte Schicht 4, die zylinderförmige, vorzugsweise kreisförmige Umrisse aufweisende Verbindungselemente 4a aufweist. Das Muster der auf der piezokeramischen Schicht aufgedruckten, strukturierten Schicht ist also eines von voneinander beanstandeten, pfeilerförmigen Verbindungselementen. Die Verbindungselemente 4a können in diesem Muster mittels beispielsweise eines Siebdruckverfahrens auf die entsprechende piezokeramische Schicht aufgebracht werden, wobei die Positionierung der Verbindungselemente innerhalb des Stapels gemäß der vorhergehenden Figuren 2A bis 2E organisiert sein könnte. Entsprechend können die strukturierten Schichten neben einer Elektrodenschicht 3 oder neben einem unbedruckten Bereich einer piezokeramischen Schicht 2 angeordnet sein, weswegen der Bereich neben der strukturierten Schicht 4 in dieser Figur mit beiden Bezugszeichen 2 und 3 markiert ist. Die Verbindungselemente 4a sind durchgehend und mit zwei in Stapelrichtung benachbarten piezokeramischen Schichten 2 verbunden. Das sind sie bereits in dem Zustand des Stapels, bevor er verpresst wird.

Die strukturierte Schicht umfasst neben den Verbindungselementen 4a zumindest vor dem Verpressen des Stapels eine oder mehrere Lücken bzw. Hohlräume 4b.

Figur 3B zeigt eine gitterförmiges Verbindungselement 4a einer strukturierten Schicht 4, die auf einem Randbereich einer piezokeramischen Schicht 3 angeordnet ist und bis zu einem auf einer Seitenfläche des Stapels angeordneten Außenkontakt reichen kann. Auch diese Verbindungsstruktur kann mittels eines Siebdruckverfahrens auf die piezokeramische Schicht gedruckt werden.

Figur 3C zeigt eine alternative Ausführung einer strukturierten Schicht 4, deren Strukturen bzw. Verbindungselemente 4a ringförmig und konzentrisch in einem Randbereich einer piezokeramischen Schicht 3 angeordnet sind. Insbesondere sind die jeweiligen Verbindungselemente rechteckförmig.

Die Verbindungselemente 4a der strukturierten Schicht 4 können durch die entsprechend geformten Aussparungen einer Maske auf die gewünschte piezokeramische Schicht 2 aufgedruckt werden.

Es kann ein keramisches oder eine metallisches Material durch ein Sieb bzw. durch eine Maske gepresst werden, um die erwünschte Struktur auf der piezokeramischen Schicht zu erzeugen.

Figur 4a zeigt einen Längsschnitt eines Bereichs des mit den vorhergehenden Figuren bereits gezeigten Stapels, wobei der gezeigte Bereich eine piezoelektrisch inaktive Zone des Stapels umfasst. Es werden verstapelte benachbarte piezokeramische Schichten 2 gezeigt, zwischen denen eine strukturierte Schicht 4 angeordnet ist. Diese umfasst mehrere Verbindungselement 4a in der Form von stehenden Zylindern oder Pfeilern, durch die die entsprechenden piezokeramischen Schichten bereits miteinander verbunden sind. Neben den Verbindungselementen 4a sind Zwischenräume 4b vorhanden. Die Zwischenräume sind vor dem Verpressen zunächst mit Luft oder mit einem beim Verpressen entfernbaren Medium gefüllt.

Figur 4b zeigt den Zustand des mit der Figur 4b gezeigten Bereiches des Stapels bei bzw. nach dem Verpressen des Stapels. Die zuvor noch vorhandenen Lücken 4b sind inzwischen aufgrund des Pressvorgangs mit Material der piezokeramischen Schichten 2 gefüllt, und zwar derart, dass durch den oder die Zwischenräume neben den Verbindungselementen 4a eine mechanische Verbindung zwischen den piezokeramischen Schichten zustande kommt. Dabei ist jedoch die beim Verpressen entstandene Festigkeit der mechanischen Verbindung im Bereich der Verbindungselemente immer noch höher, als diejenige im Bereich der mit dem piezokeramischen Material gefüllten Zwischenräume. Es ist beim Verpressen jedoch nicht auszuschließen, dass der Zwischenraum neben den Verbindungselementen nach wie vor eine oder mehrere Lücken aufweist. Dies ändert jedoch nichts weiter an dem Umstand, dass eine mechanische Verbindung geringerer Festigkeit zwischen den Verbindungselementen in diesem Zwischenraum dennoch zustande kommt.

Die Flächen der piezokeramischen Schichten, auf denen die strukturierten Schichten 4 aufgebracht sind, können größer, kleiner oder gleich groß sein, wie die Fläche eines isolierenden Bereichs zwischen einer Elektrodenschicht und einem Außenkontakt von Gegenpolarität, der auf eine Seitenfläche des Stapels angeordnet ist.

Die Struktur, Strukturen bzw. Verbindungselemente einer strukturierten Schicht können aus einem Metall oder aus einem elektrisch nicht leitendem Material bestehen bzw. die entsprechenden Materialien zumindest enthalten. Vorzugsweise sind diese Materialien identisch mit denen in den Elektrodenschichten oder in den piezokeramischen Schichten desselben piezoelektrischen Vielschichtbauelements. Vorteilhafterweise ermöglicht dies die Verhinderung von zusätzlichen chemischen Reaktionen zwischen unterschiedlichen Materialien des Vielschichtbauelements, insbesondere während seiner Herstellung.

Die Anzahl von piezokeramischen Schichten, auf die die beschriebenen strukturierten Schichten aufgebracht sind, kann beliebig groß sein. Jedoch ist auf zumindest einer piezokeramischen Schicht eine strukturierte Schicht der beschriebenen Art aufgebracht. Es können jedoch auch alle piezokeramische Schichten im Vielschichtbauelement mit einer strukturierten Schicht bedruckt sein.

Die folgende Tabelle zeigt bevorzugte Verhältnisse zwischen der Summe der Flächen der Verbindungselemente 4a einer strukturierten Schicht und der Summe der Flächen der Zwischenräumen 4b neben den Verbindungselementen.

| | Summe der Flächen von Verbindungselemente | Summe der Flächen von Zwischenräumen |
|---|---|---|
| bevorzugt | von 10 zu | 1 |
| | bis 1 zu | 10 |
| Weiter bevorzugt | von 2 zu | 1 |
| | von 1 zu | 4 |

**Bezugszeichenliste**

| | |
|---|---|
| 1 | Stapel mit piezokeramischen Schichten und Elektrodenschichten |
| 2 | piezokeramische Schicht |
| 3 | Elektrodenschicht |
| 4 | strukturierte Schicht |
| 4a | Verbindungselement einer strukturierten Schicht |
| 4b | Zwischenraum neben einem Verbindungselement |
| 5a | erster Außenkontakt |
| 5b | zweiter Außenkontakt |
| | |
| IZ | Inaktive Zone des Stapels |
| AZ | Aktive Zone des Stapels |

## Patentansprüche

1. Piezoelektrisches Vielschichtbauelement, aufweisend einen Stapel (1) von übereinander angeordneten piezokeramischen Schichten (2) und Elektrodenschichten (3), wobei
- zumindest eine piezokeramische Schicht mit einer nach einem vorgegebenen Muster strukturierten Schicht (4) in einer piezoelektrisch inaktiven Zone (IZ) des Stapels bedruckt ist, und wobei
- die strukturierte Schicht zumindest ein Verbindungselement (4a) aufweist, durch das in Stapelrichtung benachbarte piezokeramische Schichten mit einer ersten Festigkeit mechanisch miteinander verbunden sind, und wobei
- die strukturierte Schicht Zwischenräume (4b) aufweist, die zumindest teilweise mit piezokeramischem Material der benachbarten piezokeramischen Schichten gefüllt sind, und wobei
- die benachbarten piezokeramischen Schichten in den Zwischenräumen mit einer zweiten Festigkeit mechanisch miteinander verbunden sind, welche geringer ist, als die erste Festigkeit.

2. Piezoelektrisches Vielschichtbauelement nach Anspruch 1, bei dem die mechanische Verbindung zweiter Festigkeit zwischen benachbarten piezokeramischen Schichten (2) in den Zwischenräumen (4b) während eines Verpressens des Stapels des Vielschichtbauelements entstanden ist.

3. Piezoelektrisches Vielschichtbauelement nach einem der vorhergehenden Ansprüche, bei dem die Verbindungselemente (4a) stehende zylinderförmige Strukturen umfassen.

4. Piezoelektrisches Vielschichtbauelement nach Anspruch 3, bei dem die zylinderförmigen Strukturen mit Abständen zueinander in gleichmäßiger Anordnung vorhanden sind.

5. Piezoelektrisches Vielschichtbauelement nach einem der vorhergehenden Ansprüche, bei dem das zumindest eine Verbindungselement (4a) eine gitterförmige Struktur (4b) umfasst.

6. Piezoelektrisches Vielschichtbauelement nach einem der vorhergehenden Ansprüche, bei dem das zumindest eine Verbindungselement (4a) eine ringförmige Struktur (4b) umfasst.

7. Piezoelektrisches Vielschichtbauelement nach Anspruch 6, bei dem die strukturierte Schicht (4) mehrere Verbindungselemente (4a) in der Form von mehreren ringförmigen, konzentrisch angeordneten Strukturen umfasst.

8. Piezoelektrisches Vielschichtbauelement nach einem der vorhergehenden Ansprüche, bei dem die strukturierte Schicht (4) ein gleiches Metall enthält, das in den Elektrodenschichten (3) enthalten ist.

9. Piezoelektrisches Vielschichtbauelement nach einem der vorhergehenden Ansprüche, bei dem die strukturierte Schicht (4) ein gleiches Material enthält, das in den piezokeramischen Schichten (2) enthalten ist.

10. Piezoelektrisches Vielschichtbauelement nach einem der vorhergehenden Ansprüche, bei dem die strukturierte Schicht (4) auf derselben piezokeramischen Schicht (2) angeordnet ist, wie eine Elektrodenschicht (3).

11. Piezoelektrisches Vielschichtbauelement nach einem der Ansprüche 1 bis 9, bei dem die strukturierte Schicht (4) auf einer anderen piezokeramischen Schicht (2) angeordnet ist, als auf einer, auf der eine Elektrodenschicht (3) angeordnet ist.

12. Piezoelektrisches Vielschichtbauelement nach einem der vorhergehenden Ansprüche, bei dem die strukturierte Schicht (4) zusätzlich in der aktiven Zone (AZ) des Stapels (1) auf einer piezoelektrischen Schicht (2) aufgedruckt ist.

13. Piezoelektrisches Vielschichtbauelement nach einem der vorhergehenden Ansprüche, bei dem mehrere strukturierte Schichten (4) auf mehreren piezokeramischen Schichten (2) über die Höhe des Stapels (1) verteilt sind.

14. Verfahren zur Herstellung eines piezoelektrischen Vielschichtbauelements, bei dem
- ein Stapel (1) von Elektrodenschichten und bedruckten piezokeramischen Schichten (2) gebildet wird, wobei
- zumindest eine piezokeramische Schicht zumindest in einer piezoelektrisch inaktiven Zone mit einer mit einem vorgegebenen Muster strukturierten Schicht (4) bedruckt wird, und
- das vorgegebene Muster der aufgedruckten strukturierten Schicht benachbarte piezokeramische Schichten mechanisch verbindende Verbindungselemente (4a) und neben den Verbindungselementen vorhandene Zwischenräume (4b) ergibt,
- der Stapel derart verpresst wird, dass die benachbarten piezokeramischen Schichten erweichen und ihr jeweiliges Material in die Zwischenräume (4b) fließt, sodass
- die mechanische Verbindung zwischen den benachbarten piezokeramischen Schichten in den Zwischenräumen weniger fest ist, als die beim Verpressen durch die Verbindungselemente ergebende mechanische Verbindung zwischen den piezoelektrischen Schichten.

15. Verfahren nach Anspruch 14, bei dem die strukturierte Schicht (4) mittels eines Siebdruckverfahrens auf die zumindest eine piezoelektrische Schicht (2) aufgedruckt wird.

## Claims

1. Piezoelectric multilayer component, comprising a stack (1) of piezoceramic layers (2) and electrode layers (3) arranged one above another, wherein
- at least one piezoceramic layer is printed with a layer (4) structured according to a predefined pattern in a piezoelectrically inactive zone (IZ) of the stack, and wherein
- the structured layer has at least one connecting element (4a) by which piezoceramic layers that are adjacent in the stacking direction are mechanically connected to one another with a first strength, and wherein
- the structured layer has interspaces (4b) filled at least in part with piezoceramic material of the adjacent piezoceramic layers, and wherein
- the adjacent piezoceramic layers in the interspaces are mechanically connected to one another with a second strength, which is less than the first strength.

2. Piezoelectric multilayer component according to Claim 1, wherein the mechanical connection with second strength between adjacent piezoceramic layers (2) in the interspaces (4b) arose during pressing of the stack of the multilayer component.

3. Piezoelectric multilayer component according to any of the preceding claims, wherein the connecting elements (4a) comprise standing cylindrical structures.

4. Piezoelectric multilayer component according to Claim 3, wherein the cylindrical structures are present at distances from one another in a uniform arrangement.

5. Piezoelectric multilayer component according to any of the preceding claims, wherein the at least one connecting element (4a) comprises a lattice-shaped structure (4b).

6. Piezoelectric multilayer component according to any of the preceding claims, wherein the at least one connecting element (4a) comprises a ring-shaped structure (4b).

7. Piezoelectric multilayer component according to Claim 6, wherein the structured layer (4) comprises a plurality of connecting elements (4a) in the form of a plurality of ring-shaped structures arranged concentrically.

8. Piezoelectric multilayer component according to any of the preceding claims, wherein the structured layer (4) contains an identical metal that is contained in the electrode layers (3).

9. Piezoelectric multilayer component according to any of the preceding claims, wherein the structured layer (4) contains an identical material that is contained in the piezoceramic layers (2).

10. Piezoelectric multilayer component according to any of the preceding claims, wherein the structured layer (4) is arranged on the same piezoceramic layer (2) as an electrode layer (3).

11. Piezoelectric multilayer component according to any of Claims 1 to 9, wherein the structured layer (4) is arranged on a different piezoceramic layer (2) than on one on which an electrode layer (3) is arranged.

12. Piezoelectric multilayer component according to any of the preceding claims, wherein the structured layer (4) is additionally printed on a piezoelectric layer (2) in the active zone (AZ) of the stack (1).

13. Piezoelectric multilayer component according to any of the preceding claims, wherein a plurality of structured layers (4) on a plurality of piezoceramic layers (2) are distributed over the height of the stack (1).

14. Method for producing a piezoelectric multilayer component, wherein
- a stack (1) of electrode layers and printed piezoceramic layers (2) is formed, wherein
- at least one piezoceramic layer is printed at least in a piezoelectrically inactive zone with a layer (4) structured with a predefined pattern, and
- the predefined pattern of the printed-on structured layer produces connecting elements (4a) that mechanically connect adjacent piezoceramic layers and interspaces (4b) that are present alongside the connecting elements,
- the stack is pressed in such a way that the adjacent piezoceramic layers soften and their respective material flows into the interspaces (4b), such that
- the mechanical connection between the adjacent piezoceramic layers in the interspaces is not as strong as the mechanical connection between the piezoelectric layers that is produced by the connecting elements during the pressing.

15. Method according to Claim 14, wherein the structured layer (4) is printed onto the at least one piezoelectric layer (2) by means of a screen printing method.

## Revendications

1. Composant piézoélectrique multicouche présentant un empilement (1) de couches céramiques (2) et de couches d'électrodes (3) disposées les unes au-dessus des autres, et dans lequel
au moins une couche piézocéramique est imprimée par une couche (4) structurée selon un motif prédéterminé dans une zone piézoélectriquement inactive (IZ) de l'empilement,
la couche structurée présente au moins un élément de liaison (4a) par lequel des couches piézocéramiques voisines dans la direction de l'empilement sont reliées mécaniquement les unes aux autres à une première résistance mécanique,
la couche structurée présente des espaces intermédiaires (4b) remplis au moins en partie de matériau piézocéramique des couches piézocéramiques voisines et
dans les espaces intermédiaires, les couches piézocéramiques voisines sont reliées mécaniquement les unes aux autres à une deuxième résistance mécanique plus basse que la première résistance mécanique.

2. Composant piézoélectrique multicouche selon la revendication 1, dans lequel la liaison mécanique à une deuxième résistance mécanique entre des couches piézocéramiques voisines (2) se forme dans les espaces intermédiaires (4b) pendant une compression de l'empilement du composant multicouche.

3. Composant piézoélectrique multicouche selon l'une des revendications précédentes, dans lequel les éléments de liaison (4a) comportent des structures cylindriques debout.

4. Composant piézoélectrique multicouche selon la revendication 3, dans lequel les structures cylindriques sont agencées à distance mutuelle de manière régulière.

5. Composant piézoélectrique multicouche selon l'une des revendications précédentes, dans lequel le ou les éléments de liaison (4a) comportent une structure (4b) en forme de grille.

6. Composant piézoélectrique multicouche selon l'une des revendications précédentes, dans lequel le ou les éléments de liaison (4a) comportent une structure (4b) en forme d'anneau.

7. Composant piézoélectrique multicouche selon la revendication 6, dans lequel la couche structurée (4) comporte plusieurs éléments de liaison (4a) qui présentent la forme de plusieurs structures annulaires disposées concentriquement.

8. Composant piézoélectrique multicouche selon l'une des revendications précédentes, dans lequel la couche structurée (4) contient le même métal que celui que contiennent les couches d'électrodes (3).

9. Composant piézoélectrique multicouche selon l'une des revendications précédentes, dans lequel la couche structurée (4) contient le même métal que celui que contiennent les couches piézocéramiques (2).

10. Composant piézoélectrique multicouche selon l'une des revendications précédentes, dans lequel la couche structurée (4) est disposée sur la même couche piézocéramique (2) que la couche d'électrode (3).

11. Composant piézoélectrique multicouche selon l'une des revendications 1 à 9, dans lequel la couche structurée (4) est disposée sur une autre couche piézocéramique (2) que celle sur laquelle une couche d'électrode (3) est disposée.

12. Composant piézoélectrique multicouche selon l'une des revendications précédentes, dans lequel la couche structurée (4) est de plus imprimée dans la zone active (AZ) de l'empilement (1) sur une couche piézoélectrique (2).

13. Composant piézoélectrique multicouche selon l'une des revendications précédentes, dans lequel plusieurs couches structurées (4) sont réparties sur plusieurs couches piézocéramiques (2) suivant la hauteur de l'empilement (1).

14. Procédé de fabrication d'un composant piézoélectrique multicouche, dans lequel
un empilement (1) de couches d'électrode et de couches piézocéramiques imprimées (2) est formé,
au moins une couche piézocéramique est imprimée par une couche (4) structurée selon un motif prédéterminé au moins dans une zone piézoélectriquement inactive,
le motif prédéterminé de la couche structurée imprimée fournit des éléments de liaison (4a) qui relient mécaniquement des couches piézocéramiques voisines et des espaces intermédiaires (4b) entre les éléments de liaison,
la pile est comprimée de telle sorte que les couches piézocéramiques voisines s'amollissent et que leur matériau s'écoule dans des espaces intermédiaires (4b) de telle sorte que
la liaison mécanique réalisée dans les espaces intermédiaires par les éléments de liaison lors de la compression soit moins solide entre les couches piézocéramiques voisines que la liaison mécanique entre les couches piézoélectriques.

15. Procédé selon la revendication 14, dans lequel la couche structurée (4) est imprimée sur la ou les couches piézoélectriques (2) au moyen d'une opération de sérigraphie.
